# FASCICULE DE BREVET EUROPEEN

(11) **EP 1 676 389 B1**
(45) Date de publication et mention de la délivrance du brevet: **28.11.2018**
(21) Numéro de dépôt: 04817294.4
(22) Date de dépôt: 27.09.2004
(51) Int. Cl.: H04L 1/00

(54) **METHODE DE RECONSTRUCTION DE PAQUETS PERDUS ET APPAREIL IMPLEMENTANT LA METHODE**
VERFAHREN ZUR REKONSTRUKTION VERLORENER PAKETE UND EINRICHTUNG ZUR AUSFÜHRUNG DES VERFAHRENS
METHOD FOR LOST PACKET RECONSTRUCTION AND DEVICE FOR CARRYING OUT SAID METHOD

(30) Priorité: 23.10.2003 FR 0312391
(43) Date de publication de la demande: 05.07.2006
(73) Titulaire: Thomson Licensing, 92130 Issy-les-Moulineaux (FR)
(72) Inventeur: CHAMPEL, Mary-Luc, F-35220 Marpiré (FR)
(74) Mandataire: Le Dantec, Claude
(86) Numéro de dépôt international: PCT/FR2004/050464
(87) Numéro de publication internationale: WO 2005/041466

(56) Documents cités:
- EP-A- 1 059 757
- US-A- 5 615 222
- US-A- 5 757 825

## Description

La présente invention concerne la correction d'erreur dans le cadre de l'envoi de données numériques sous forme de paquets.

Lors de l'envoi de données numériques sur un réseau sous forme de paquets de données il arrive que des erreurs de transmission affectent les paquets. Les réseaux permettant le transfert de données numériques sous forme de paquets ont des caractéristiques propres, telles que la bande passante, la latence ou la fiabilité, qui varient d'un type de réseau à un autre. Selon le type de réseau, on peut remarquer une sensibilité différente à différents type d'erreurs susceptibles de se produire lors de la transmission de données par paquet sur ce réseau. Parmi les types d'erreurs susceptibles de se produire se trouvent la transmission d'un paquet avec un bit erroné, la perte d'un paquet aléatoirement, la perte d'une suite de paquets adjacents, la duplication d'un paquet ou d'une suite de paquets.

US-A-5 615 222 publié le 25 mars 1997 décrit une méthode de détection d'échantillons erronés dans un flux audio, un échantillon se composant typiquement de 4 bits, les échantillons erronés détectés n'étant pas utilisés dans la reconstruction du flux audio.

Pour faire face à ces erreurs, il existe traditionnellement deux types de méthodes. D'une part les méthodes de détection d'erreur, qui permettent de détecter qu'un paquet transmis est erroné et de l'ignorer. Généralement ces méthodes sont utilisées quand le protocole de transmission permet de demander un nouvel envoi du paquet perdu. On peut citer ici la méthode du CRC (Cyclic Redundancy Checking) et le protocole TCP (Transfer Control Protocol) sur des réseaux de type IP. D'autre part, il existe des méthodes qui permettent, non seulement la détection d'un paquet erroné, mais aussi sa reconstruction. Ces méthodes sont connues sous l'acronyme FEC (Forward Error Correction) et sont bien adaptées à des protocoles où la demande de réexpédition d'un paquet de données erroné n'est pas possible. On peut citer ici le cas des protocoles de diffusion de contenu multimédia en temps réel où le respect du temps réel est incompatible avec la réexpédition des paquets erronés. Le protocole RTP (Real Time Protocol) correspond à ce dernier cas.

Le principe général de fonctionnement des méthodes FEC est l'application d'une fonction, par exemple un XOR, sur un ensemble de paquets de données. Le résultat de cette fonction donne un paquet, appelé paquet correcteur, qui est transmis en sus des paquets de données ayant servi à le générer. Lorsqu'un paquet est détecté comme étant erroné, le paquet correcteur, associé aux paquets correctement transmis, permet de reconstruire le paquet erroné. Mais cette méthode a des limites en ce sens qu'il existe des erreurs qui ne sont pas corrigeables. En effet, si deux paquets sont erronés dans l'ensemble des paquets ayant servi à générer un paquet correcteur par la fonction XOR, celui-ci ne pourra pas suffire à reconstruire les deux paquets erronés. La stratégie utilisée dans le choix des paquets servant à générer le paquet correcteur est donc cruciale sur l'efficacité de la méthode de correction. En particuliers, cette stratégie va dépendre du type d'erreurs arrivant le plus souvent sur le type de réseau utilisé. Par exemple le calcul de la fonction de correction sur N paquets contigus permettra de corriger des erreurs aléatoires pas trop nombreuses mais sera impuissante devant une série de paquets perdus. Pour faire face aux séries de paquets perdus, il est connu, par exemple dans le document «Code of Practice » du forum Pro-MPEG, de calculer la fonction de correction sur un ensemble de D paquets pris périodiquement tous les L paquets. La fonction est appliquée, aux paquets i, i+L, i+2L,... , i+(D-1)L. De cette façon une série de paquets erronés d'au plus L paquets contigus pourra être corrigée par la méthode.

Le problème de cette méthode est que, bien que très bien adaptée aux séries de paquets erronés, elle se révèle comme ayant un taux statistique de succès qui décroît très vite lorsque le taux d'erreurs aléatoires augmente. Le besoin se fait donc sentir d'une méthode qui résiste mieux à une augmentation du taux d'erreurs aléatoires tout en gardant une bonne correction des séries de paquets de données.

Le but de l'invention est donc de proposer une telle méthode. Elle consiste à appliquer la fonction de correction, aux D paquets tels que décrits précédemment mais également de l'appliquer au L paquets numérotés i, i+1, i+2, ..., i+ L-1. De cette façon, chaque paquet de données sert au calcul de deux paquets correcteurs, et le taux de correction en présence d'erreurs aléatoires augmente significativement tout en gardant une bonne correction des séries de paquets erronés.

L'invention concerne une méthode de sécurisation d'un flux de paquets de données contenant les étapes suivantes : le rangement des paquets à envoyer dans une matrice de D lignes et L colonnes, l'application à chaque ligne et chaque colonne de la matrice d'une fonction de correction d'erreur, dont le résultat est un paquet correcteur puis l'envoi des paquets correcteurs résultant en sus des paquets de données.

Selon un autre aspect de l'invention, la fonction correctrice est également appliquée à la ligne constituée des paquets correcteurs résultant de l'application de la fonction correctrice à chaque colonne de la matrice générant un paquet correcteur supplémentaire.

Selon un autre aspect de l'invention, la fonction correctrice est également appliquée à la colonne constituée des paquets correcteurs résultant de l'application de la fonction correctrice à chaque ligne de la matrice générant un paquet correcteur supplémentaire.

Selon un autre aspect de l'invention, les entêtes des paquets correcteurs contiennent un champ permettant de distinguer s'ils ont été calculés sur une ligne ou une colonne de la matrice.

Selon un autre aspect de l'invention, les paquets correcteurs sont transmis dans le même flux que les paquets de données.

Selon un autre aspect de l'invention, les paquets correcteurs sont transmis dans un flux différent de celui véhiculant les paquets de données.

L'invention concerne également une méthode de reconstruction des paquets perdus dans un flux de paquets de données contenant les étapes suivantes : le rangement des paquets reçus dans une matrice de D lignes et L colonnes en tenant compte de leur numéro de séquence, l'application à chaque ligne et chaque colonne de la matrice contenant au moins un paquet perdu d'une fonction de reconstruction des paquets manquants utilisant les paquets reçus et le paquet correcteur correspondant à la ligne ou à la colonne.

Selon un autre aspect de l'invention, la fonction de reconstruction peut également être appliquée à une ligne ou une colonne de paquets correcteurs en utilisant un paquet correcteur supplémentaire généré à cet effet.

L'invention concerne également un appareil émetteur d'un flux de paquets de données sur un réseau contenant des moyens de calcul générant un paquet correcteur par application d'une fonction correctrice à un ensemble de paquets de données et caractérisée en ce que l'appareil contient des moyens pour appliquer cette fonction aux lignes et aux colonnes d'une matrice formée de paquets de données.

Selon un autre aspect de l'invention, les moyens appliquant la fonction le font selon la méthode décrite dans le brevet.

L'invention concerne également un appareil récepteur d'un flux de paquets de données sur un réseau contenant des moyens de calcul de paquets perdus en fonction des paquets de données et de paquets correcteurs reçus caractérisé en ce que l'appareil dispose d'un moyen permettant d'appliquer ces moyens de calculs aux lignes et aux colonnes d'une matrice de paquets de données du flux ainsi qu'aux paquets correcteurs correspondant à ces lignes et ces colonnes.

Selon un autre aspect de l'invention les paquets correcteurs sont générés selon l'une des méthodes décrites dans le brevet.

L'invention sera mieux comprise, et d'autres particularités et avantages apparaîtront à la lecture de la description qui va suivre, la description faisant référence aux dessins annexés parmi lesquels :
La figure 1 représente un schéma de l'application de la fonction de correction aux paquets de données.
La figure 2 représente la structure d'un paquet correcteur placé dans un paquet selon le protocole RTP.
La figure 3 représente l'entête d'un paquet correcteur selon la RFC 2733.
La figure 4 représente l'entête d'un paquet correcteur selon l'exemple de réalisation de l'invention décrit.
La figure 5 représente l'architecture matérielle d'un appareil émetteur ou récepteur selon l'exemple de réalisation de l'invention.

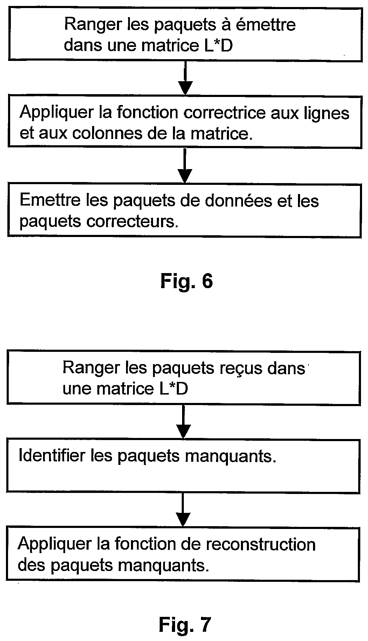

La figure 6 représente les étapes de la méthode pour l'émetteur.
La figure 7 représente les étapes de la méthode pour le récepteur.

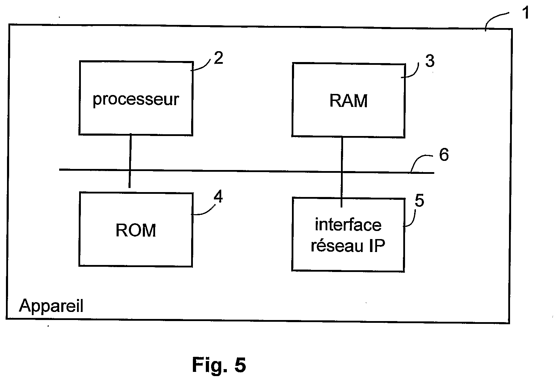

La figure 5 représente l'architecture interne d'un appareil émetteur ou récepteur 1 qui possède de la mémoire morte (ROM 4) lui permettant de stocker des programmes et des données, de la mémoire vive (RAM 3) qui lui permet de charger ces programmes en vue d'une exécution par le processeur 2. Cet appareil est connecté à un réseau de type IP par une interface réseau 5 ce qui lui permet d'émettre ou de recevoir les flux. Ces composants communiquent par l'intermédiaire d'un bus interne 6.

L'exemple de réalisation de l'invention se place dans le cadre du transfert de données numériques en temps réel sur un réseau de type IP. Les données sont transmises, dans cet exemple de réalisation, sous forme d'un flux via le protocole RTP (Real Time Protocol). Comme déjà cité, la RFC 2733 décrit une façon standard de corriger les paquets de données transmis par le protocole RTP. Cette méthode a fait l'objet d'une extension décrite dans le document « Code of Practice » du forum Pro-MPEG. L'exemple de réalisation de l'invention qui va être maintenant décrit est un perfectionnement compatible avec cette méthode.

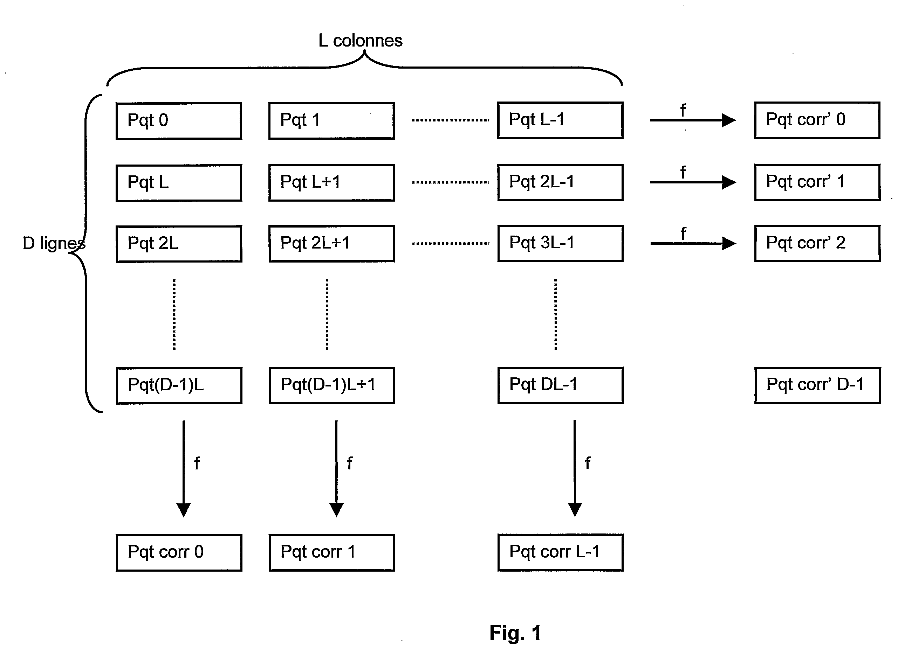

Dans cet exemple de réalisation, les paquets de données sont séparés en ensembles de L*D paquets. Ils sont ensuite rangés dans une matrice de D lignes et L colonnes, comme on peut le voir sur la figure 1. L et D sont choisis en fonction de l'efficacité que l'on veut obtenir. La façon dont ces paramètres influent sur l'efficacité de la méthode correctrice sera décrite plus loin. Une fonction correctrice est ensuite appliquée à chaque colonne de la matrice, la même fonction correctrice est également appliquée à chaque ligne de la matrice. Cette fonction correctrice peut être un XOR, ce qui est le plus simple à implémenter, mais d'autres fonctions sont possibles comme le Reed-Solomon ou un code de Hamming. Ces fonctions sont plus performantes mais plus coûteuses en calcul. Quelle que soit la fonction de correction choisie, le résultat de l'application de cette fonction à un ensemble de paquets, une ligne ou une colonne de la matrice en l'occurrence, a pour résultat un paquet que l'on appelle le paquet correcteur. La méthode a donc pour résultat L paquets correcteurs correspondant à l'application de la fonction à chaque colonne et D paquets correcteurs correspondant à l'application de la fonction à chaque ligne. Il est également possible d'ajouter un paquet correcteur calculé par l'application de la fonction correctrice sur les paquets correcteurs eux-même, ce qui ajoute un deuxième niveau de protection permettant de corriger une perte d'un paquet correcteur.

Ces paquets doivent être transmis au destinataire du flux de donnée. Cette transmission peut être faite de plusieurs manières. Il est possible de transmettre ces paquets correcteurs dans le même flux que les paquets de données, mais ils sont alors soumis aux même aléas de transmission que le flux qu'ils protègent. Ils peuvent également être transmis dans un flux à part, ce qui augmente la résistance aux erreurs.

La méthode décrite par le forum Pro-MPEG consiste à calculer et à envoyer les paquets correcteurs calculés à partir des colonnes de la matrice. La méthode décrite dans le brevet, dans la mesure où elle envoie ces mêmes paquets, reste compatible avec celle de Pro-MPEG. En effet, des appareils récepteurs suivant ce standard vont ignorer les paquets correcteurs calculés sur les lignes de la matrice et pourront donc fonctionner de la même manière avec un émetteur selon l'invention et avec un émetteur suivant la méthode Pro-MPEG.

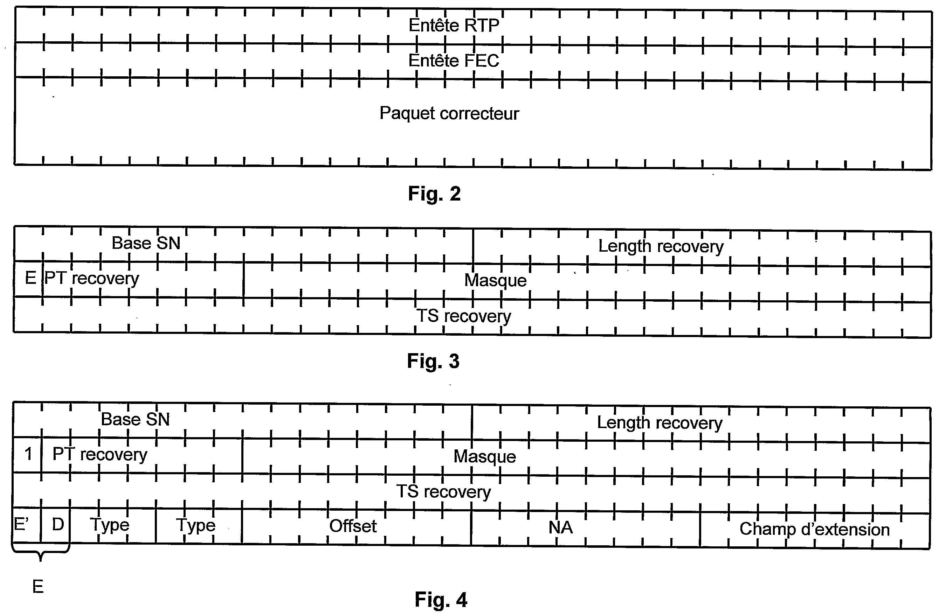

La structure d'un paquet, tel que décrit dans la RFC est représentée dans la figure 2. Elle consiste en un entête de paquet RTP dont la description peut être trouvée dans la RFC 1889. Cet entête est suivi d'un entête FEC puis du paquet correcteur proprement dit. La structure d'un entête FEC selon la RFC 2733 est représentée à la figure 3. Cet entête contient un champ « base SN » qui contient le numéro de séquence le plus faible de l'ensemble des paquets de données ayant servi à la construction du paquet correcteur. Le champ « length recovery » est utilisé pour déterminer la longueur de n'importe quel paquet de données. Il est construit en appliquant la fonction correctrice à l'ensemble formé des longueurs de chaque paquet de données. Le champ « E » sert à indiquer une extension de l'entête. Le champ « PT recovery » est obtenu en appliquant la fonction correctrice au champ «type » des paquets de données. Le champ « Masque » est un champ de 24 bits qui sert à déterminer quels sont les paquets de données servant à la construction du paquet correcteur. Si le bit i est à un, cela signifie que ce sont les paquets N + i qui ont servi à la construction du paquet correcteur. N est la base stockée dans le champ « base SN ». Le champ «TS recovery» est calculé par application de la fonction correctrice aux marques temporelles (timestamp en anglais) des paquets de données. Il permet la reconstruction de ces marques.

On voit que par ce mécanisme, il n'est possible que de calculer des paquets correcteurs sur des ensembles d'un maximum de 24 paquets de données. Pour dépasser cette contrainte, une extension de cet entête est définie dans le document «Code Of Practice » du forum Pro-MPEG. Cette extension est représentée dans la figure 4. On y retrouve le même entête que précédemment où le champ d'extension est marqué à 1. Un nouveau champ d'extension «E » sur 2 bits est ajouté qui détermine l'utilisation du champ « champ d'extension ». Le champ «type » indique quelle fonction correctrice est utilisée, 0 pour le XOR, 1 pour un code de hamming, 2 pour un Reed/Solomon. Le champ « index » est utilisé pour ordonner les paquets FEC dans le cas où le résultat de la fonction correctrice dépasserait la taille maximum d'un paquet. Ce peut être le cas pour des fonctions correctrices complexes. Le champ « offset » détermine la période choisie pour sélectionner les paquets de données, elle correspond au paramètre L de la matrice. Le champ « NA » (Number of Associated) détermine le nombre de paquets de données associés pour la génération du paquet correcteur, ce nombre correspond au paramètre D de la matrice. Le champ « champ d'extension » est réservé à des usages futurs. Le champ « masque » est devenu inutile et est initialisé par des octets de remplissage à 0.

La modification apportée par l'invention consiste à séparer le champ « E » de deux bits, en un nouveau champ « E' » sur un bit et un champ « D » sur un bit également qui détermine si le paquet correcteur en question est calculé sur les colonnes, dans quel cas ce champ « D » est mis à 0. Dans le cas où le paquet correcteur serait calculé sur une ligne, ce champ D est mis à 1. On voit que par ce mécanisme, un paquet correcteur calculé sur une colonne reste parfaitement identique au même paquet calculé selon la méthode du forum Pro-MPEG, tandis que les paquets supplémentaires calculés sur les lignes sont identifiables par la présence du champ D à 1, ce qui revient à mettre à un le champ d'extension « E » sur deux bits si on interprète le paquet selon la méthode Pro-MPEG signalant que ce paquet utilise une extension du format définit par le forum.

Lors de la réception des paquets, le receveur va stocker dans un tampon les paquets reçus. La taille de ce tampon doit permettre de stocker au moins L fois D paquets de données plus les L plus D paquets correcteurs correspondant. La distinction entre les paquets de données et les paquets correcteurs est faite par le champ « Type » de l'entête RTP tel que décrit dans la RFC 1889 décrivant ce protocole. Il sera possible d'identifier les paquets de données entre eux grâce à leur numéro de séquence et les paquets correcteurs entre eux grâce au champ « base SN » de leur entête. La connaissance des paquets manquants va alors permettre de tenter leur reconstruction en utilisant la fonction correctrice et les paquets correcteurs. Par exemple, si la fonction correctrice utilisée est le XOR, il est possible de corriger la perte d'un paquet de données dans un ensemble de paquets de données ayant servi à générer un paquet correcteur, à l'aide de ce paquet correcteur. On va donc repérer dans la matrice des paquets reçus, les lignes et les colonnes ne contenant qu'un paquet perdu pour les reconstruire avec le paquet correcteur correspondant. La correction peut, par exemple, être effectuée par la méthode suivante :
- Calcul d'un vecteur NLi du nombre de paquets de données manquants dans la ligne i.
- Calcul d'un vecteur NCi du nombre de paquets de données manquants dans la colonne i.
- Tant qu'il reste un paquet manquant dans la matrice faire :
   ∘ Trouver l'indice p minimum tel que NLp= 1 ;
      ▪ Si un tel p existe :
         - Trouver l'indice de colonne q correspondant au paquet manquant
         - Reconstruire le paquet d'indice p et q qui manque par application de la fonction XOR sur les autres paquets de la ligne et sur le paquet correcteur correspondant à cette ligne
         - NLp = 0 ; NCq = NCq-1 ;
      ▪ En l'absence d'un tel indice p trouver un indice q minimum tel que NCq = 1
         - Si un tel q existe :
            ∘ Trouver l'indice de colonne p correspondant au paquet manquant
            ∘ Reconstruire le paquet d'indice p et q qui manque par application de la fonction XOR sur les autres paquets de la ligne et sur le paquet correcteur correspondant à cette colonne
            ∘ NLp = NLp - 1 ; NCq = 0;
         - Sinon la méthode de reconstruction a échoué.

En cas de succès, tous les paquets perdus sont reconstruits.

Les paramètres L et D de la méthode devront être choisis en tenant compte des informations suivantes. Tout d'abord, le surplus généré par les paquets correcteurs qui doivent être envoyés en plus des paquets de données est de 1/L+1/D, on voit donc que choisir L et D grand va minimiser l'occupation de la bande passante nécessaire à l'utilisation de la méthode. D'autre part la méthode permet de corriger des séries de paquets perdus d'au plus L+1 paquets contigus, donc plus L va être grand plus la méthode va être efficace dans la correction de ce type d'erreurs. La méthode est capable de corriger toutes les pertes aléatoires de paquets jusqu'à un nombre de trois paquets perdus et certaines pertes aléatoires de paquets jusqu'à un nombre de D+L-1 paquets perdus. La symétrie du problème induit un maximum d'efficacité sur les pertes aléatoires de paquets lorsque L et D on la même valeur. Maintenant, la méthode nécessite des tampons dans les appareils tant émetteurs que récepteurs, d'une taille minimum de L*D paquets. On voit donc qu'il est intéressant de choisir des valeurs de L et D grandes pour maximiser l'efficacité de la méthode mais que l'on est limité par la taille des tampons en émission et en réception des appareils. Une autre limitation peut venir du temps de calcul de la fonction correctrice qui peut devenir importante pour un grand nombre de paquets et un choix de fonction complexe.

Des calculs statistiques permettent de comparer l'efficacité de la méthode avec celle décrite par le forum Pro-MPEG. On constate que, comme attendu, son efficacité est bien plus grande. Par exemple, en utilisant la fonction correctrice XOR et une matrice où L et D ont une valeur de 6, la méthode corrige 94,1 pour cent des pertes aléatoires de 6 paquets de données alors que la méthode de la RFC n'en corrige que 2,4 pour cent. La méthode se révèle donc beaucoup plus efficace pour la correction de pertes aléatoires de paquets de données dans le flux. Tandis que la méthode est capable de corriger toutes les pertes de paquets adjacents jusqu'à un nombre de D+1 paquets successifs là où la méthode Pro-MPEG ne corrige que jusqu'à un nombre de D. On voit donc que les performances sur la perte de paquets de données adjacents sont légèrement améliorées tandis que les performances sur les erreurs aléatoires sont très largement augmentées.

Il est évident, pour l'homme du métier, que l'exemple de réalisation ici décrit est non limitatif. En particulier, l'invention peut être utilisée dans le cadre de tous les protocoles de transfert de données par paquet et pas seulement dans le cadre de RTP. Il est également possible d'utiliser toute fonction correctrice, l'invention n'est pas limitée à celles qui sont citées dans le brevet.

## Revendications

1. Méthode de sécurisation d'un flux de paquets de données comprenant les étapes suivantes :
- le rangement des paquets à envoyer dans une matrice de paquets de D lignes et L colonnes ;
- l'application à chaque ligne et chaque colonne de la matrice d'une fonction de correction d'erreur, dont le résultat est un paquet correcteur permettant la reconstruction d'au moins un paquet perdu dans la ligne, respectivement la colonne, à laquelle est appliquée la fonction de correction d'erreur, ledit paquet correcteur comprenant un entête étendu, ledit entête étendu comprenant une information représentative d'une période choisie pour sélectionner les paquets de données auxquels est appliquée ladite fonction de correction d'erreur
- l'envoi des paquets correcteurs résultant en sus des paquets de données.

2. Méthode selon la revendication 1 où la fonction correctrice est également appliquée à la ligne constituée des paquets correcteurs résultant de l'application de la fonction correctrice à chaque colonne de la matrice générant un paquet correcteur supplémentaire.

3. Méthode selon la revendication 1 où la fonction correctrice est également appliquée à la colonne constituée des paquets correcteurs résultant de l'application de la fonction correctrice à chaque ligne de la matrice générant un paquet correcteur supplémentaire.

4. Méthode selon l'une quelconque des revendications précédentes où les entêtes des paquets correcteurs contiennent un champ permettant de distinguer s'ils ont été calculés sur une ligne ou une colonne de la matrice.

5. Méthode selon l'une quelconque des revendications précédentes où les paquets correcteurs sont transmis dans le même flux que les paquets de données.

6. Méthode selon l'une quelconque des revendications 1 à 4 où les paquets correcteurs sont transmis dans un flux différent de celui véhiculant les paquets de données.

7. Méthode de reconstruction des paquets perdus dans un flux de paquets de données comprenant les étapes suivantes :
- le rangement des paquets reçus dans une matrice de D lignes et L colonnes en tenant compte de leur numéro de séquence ;
- l'application à chaque ligne et chaque colonne de la matrice contenant au moins un paquet perdu d'une fonction de reconstruction des paquets manquants utilisant les paquets reçus et un paquet correcteur correspondant à la ligne ou à la colonne, ledit paquet correcteur étant reçu avec lesdits paquets reçus, ledit paquet correcteur comprenant un entête étendu, ledit entête étendu comprenant une information représentative d'une période choisie pour sélectionner les paquets de données auxquels est appliquée ladite fonction de correction d'erreur.

8. Méthode selon la revendication 7 où la fonction de reconstruction peut également être appliquée à une ligne ou une colonne de paquets correcteurs en utilisant un paquet correcteur supplémentaire généré à cet effet.

9. Appareil émetteur d'un flux de paquets de données sur un réseau, ledit appareil comprenant des moyens de calcul générant au moins un paquet correcteur par application d'une fonction correctrice à un ensemble de paquets de données, l'appareil comprenant des moyens pour appliquer cette fonction à chaque ligne et chaque colonne d'une matrice formée des paquets de données afin de générer ledit au moins un paquet correcteur permettant la reconstruction d'au moins un paquet perdu dans la ligne, respectivement la colonne, à laquelle est appliquée la fonction de correction d'erreur, ledit paquet correcteur comprenant un entête étendu, ledit entête étendu comprenant une information représentative d'une période choisie pour sélectionner les paquets de données auxquels est appliquée ladite fonction correctrice.

10. Appareil selon la revendication 9 où la fonction correctrice est également appliquée à une ligne constituée de paquets correcteurs résultant de l'application de la fonction correctrice à chaque colonne de la matrice générant un paquet correcteur supplémentaire.

11. Appareil selon l'une des revendications 9 à 10 où la fonction correctrice est également appliquée à une colonne constituée de paquets correcteurs résultant de l'application de la fonction correctrice à chaque ligne de la matrice générant un paquet correcteur supplémentaire.

12. Appareil récepteur d'un flux de paquets de données sur un réseau contenant des moyens de calcul de paquets perdus en fonction des paquets de données et de paquets correcteurs reçus, l'appareil dispose d'un moyen permettant d'appliquer ces moyens de calculs aux lignes et aux colonnes d'une matrice de paquets de données du flux ainsi qu'aux paquets correcteurs correspondant à ces lignes et ces colonnes, lesdits paquets correcteurs comprenant un entête étendu, ledit entête étendu comprenant une information représentative d'une période choisie pour sélectionner les paquets de données auxquels est appliquée une fonction de correction d'erreur.

13. Appareil selon la revendication 12 comprenant des moyens pour reconstruire les paquets perdus qui comprennent :
- des moyens pour ranger les paquets reçus dans une matrice de D lignes et L colonnes en tenant compte de leur numéro de séquence ;
- des moyens pour appliquer à chaque ligne et chaque colonne de la matrice contenant au moins un paquet perdu une fonction de reconstruction des paquets manquants, lesdits moyens utilisant les paquets reçus et le paquet correcteur correspondant à la ligne ou à la colonne.

14. Appareil selon la revendication 13 où la fonction de reconstruction est également appliquée à une ligne ou une colonne de paquets correcteurs en utilisant un paquet correcteur supplémentaire généré à cet effet.

## Patentansprüche

1. Verfahren zur Sicherung eines Stroms von Datenpaketen, das die folgenden Schritte umfasst:
- die Einordnung der zu versendenden Pakete in eine Paketmatrix von D Zeilen und L Spalten,
- die Anwendung auf jede Zeile und jede Spalte der Matrix einer Funktion zur Fehlerkorrektur, deren Ergebnis ein Korrekturpaket ist, das die Rekonstruktion von mindestens einem verloren gegangenen Paket in der Zeile respektive der Säule ermöglicht, auf welche die Funktion zur Fehlerkorrektur angewandt wird, wobei das besagte Korrekturpaket einen erweiterten Header umfasst, der besagte erweiterte Header eine repräsentative Information eines Zeitraums umfasst, der gewählt wurde, um die Datenpakete auszuwählen, auf welche die besagte Funktion zur Fehlerkorrektur angewandt wird
- das Versenden der Korrekturpakete, die zusätzlich aus den Datenpaketen resultieren.

2. Verfahren nach Anspruch 1, in welchem die korrigierende Funktion ebenfalls auf die Zeile angewandt wird, die die Korrekturpakete umfasst, die aus der Anwendung der korrigierenden Funktion auf jede Spalte der Matrix resultieren, wobei ein zusätzliches Korrekturpaket erzeugt wird.

3. Verfahren nach Anspruch 1, in welchem die korrigierende Funktion ebenfalls auf die Spalte angewandt wird, die die Korrekturpakete umfasst, die aus Anwendung der korrigierenden Funktion auf jede Zeile der Matrix resultieren, wobei ein zusätzliches Korrekturpaket erzeugt wird.

4. Verfahren nach einem der vorstehenden Ansprüche, in welchem die Header der Korrekturpakete ein Feld enthalten, das es ermöglicht zu unterscheiden, ob sie in einer Zeile oder einer Spalte der Matrix berechnet wurden.

5. Verfahren nach einem der vorstehenden Ansprüche, in welchem die Korrekturpakete in dem gleichen Strom wie die Datenpakete übertragen werden.

6. Verfahren nach einem der Ansprüche 1 bis 4, in welchem die Korrekturpakete in einem Strom übertragen werden, der von jenem verschieden ist, der die Datenpakete transportiert.

7. Verfahren zur Rekonstruktion der verloren gegangenen Pakete in einem Strom von Datenpaketen, das die folgenden Schritte umfasst:
- die Einordnung der empfangenen Pakete in eine Matrix von D Zeilen und L Spalten unter Berücksichtigung ihrer Sequenznummer;
- die Anwendung auf jede Zeile und jede Spalte der Matrix, die mindestens ein verloren gegangenes Paket enthalten, einer Funktion zur Rekonstruktion der fehlenden Pakete unter Verwendung der empfangenen Pakete und eines Korrekturpakets, das der Zeile oder der Spalte entspricht, wobei das besagte Korrekturpaket mit den besagten empfangenen Paketen empfangen wird, das besagte Korrekturpaket einen erweiterten Header umfasst, der besagte erweiterte Header eine repräsentative Information zu einem Zeitraum umfasst, der gewählt wurde, um die Datenpakete auszuwählen, auf welche die besagte Funktion zur Fehlerkorrektur angewandt wird.

8. Verfahren nach Anspruch 7, in welchem die Rekonstruktionsfunktion ebenfalls auf eine Zeile oder eine Spalte von Korrekturpaketen angewandt werden kann, indem ein zusätzliches Korrekturpaket verwendet wird, das zu diesem Zweck erzeugt wurde.

9. Gerät zum Aussenden eines Stroms von Datenpaketen über ein Netzwerk, wobei das besagte Gerät Mittel zur Berechnung umfasst, die mindestens ein Korrekturpaket durch Anwendung einer korrigierenden Funktion auf eine Gesamtheit von Datenpaketen erzeugen, wobei das Gerät Mittel umfasst, um diese Funktion auf jede Zeile und jede Spalte einer Matrix, die aus den Datenpaketen gebildet wird, anzuwenden, um das besagte mindestens eine Korrekturpaket zu erzeugen, das die Rekonstruktion von mindestens einem verloren gegangenen Paket in der Zeile respektive der Spalte ermöglicht, auf welche die Funktion zur Fehlerkorrektur angewandt wird, das Korrekturpaket einen erweiterten Header umfasst, der besagte erweiterte Header eine repräsentative Information eines Zeitraums umfasst, der gewählt wurde, um die Datenpakete auszuwählen, auf welche die besagte korrigierende Funktion angewandt wird.

10. Gerät nach Anspruch 9, bei welchem die korrigierende Funktion ebenfalls auf eine Zeile angewandt wird, die aus Korrekturpaketen besteht, die aus der Anwendung der korrigierenden Funktion auf jede Spalte der Matrix resultieren, wobei ein zusätzliches Korrekturpaket erzeugt wird.

11. Gerät nach einem der Ansprüche 9 bis 10, bei welchem die korrigierende Funktion ebenfalls auf eine Spalte angewandt wird, die aus Korrekturpaketen besteht, die aus der Anwendung der korrigierenden Funktion auf jede Zeile der Matrix resultieren, wobei ein zusätzliches Korrekturpaket erzeugt wird.

12. Gerät zum Empfangen eines Stroms von Datenpaketen über ein Netzwerk, das Mittel zur Berechnung von verloren gegangenen Paketen in Abhängigkeit von den empfangenen Datenpaketen und Korrekturpaketen umfasst, das Gerät über ein Mittel verfügt, das die Anwendung dieser Mittel zur Berechnung auf die Zeilen und die Spalten einer Matrix von Datenpaketen des Stroms sowie auf die Korrekturpakete, die diesen Zeilen und Spalten entsprechen, ermöglicht, wobei die besagten Korrekturpakete einen erweiterten Header umfassen, der besagte erweiterte Header eine repräsentative Funktion von einem Zeitraum umfasst, der gewählt wurde, um die Datenpakete auszuwählen, auf welche eine Funktion zur Fehlerkorrektur angewandt wird.

13. Gerät nach Anspruch 12, das Mittel zum Rekonstruieren der verloren gegangenen Pakete umfasst, wobei die Mittel umfassen:
- Mittel zur Einordnung der empfangenen Pakete in eine Matrix mit D Zeilen und L Spalten unter Berücksichtigung ihrer Sequenznummer
- Mittel zur Anwendung auf jede Zeile und jede Spalte der Matrix, die mindestens ein verloren gegangenes Paket enthalten, einer Funktion zur Rekonstruktion der fehlenden Pakete, wobei die besagten Mittel die empfangenen Pakete und das Korrekturpaket, das der Zeile oder der Spalte entspricht, verwenden.

14. Gerät nach Anspruch 13, bei welchem die Rekonstruktionsfunktion ebenfalls auf eine Zeile oder eine Spalte von Korrekturpaketen angewandt wird, indem ein zu diesem Zweck erzeugtes zusätzliches Korrekturpaket verwendet wird.

## Claims

1. Method for securing a data packet stream comprising the following steps:
- the storage of packets to send in a matrix of packets of D lines and L columns,
- the application at each line and each column of the matrix of an error correction function, whose result is a corrective packet enabling the reconstruction of at least one packet lost in the line, respectively the column, to which is applied the error correction function, said corrective packet comprising an extended header, said extended header comprising an information representative of a chosen period to select the data packets to which said error correction function is applied,
- the sending of the resulting corrective packets in addition to the data packets.

2. Method according to claim 1, wherein the corrective function is also applied to the line constituted by corrective packets resulting from the application of the corrective function to each column of the matrix generating an additional corrective packet.

3. Method according to claim 1, wherein the corrective function is also applied to the column constituted by corrective packets resulting from the application of the corrective function to each line of the matrix generating an additional corrective packet.

4. Method according to any one of the preceding claims, wherein the corrective packet headers contain a field that can distinguish if they were calculated on a line or a column of the matrix.

5. Method according to any one of the preceding claims, wherein the corrective packets are transmitted in the same stream as the data packets.

6. Method according to any one of claims 1 to 4, wherein the corrective packets are transmitted in a different stream from the one transporting the data packets.

7. Method for reconstructing data packets lost in a data packet stream comprising the following steps:
- the storage of packets received in a matrix of D lines and L columns taking into account their sequence number,
- the application at each line and each column of the matrix containing at least one lost packet of a reconstruction function of the missing packets received and a corrective packet corresponding to the line or the column, said corrective packet being received with said received packets, said corrective packet comprising an extended header, said extended header comprising an information representative of a chosen period to select the data packets to which said error correction function is applied.

8. Method according to claim 7, wherein the reconstruction function can also be applied to a line or a column of corrective packets by using an additional corrective packet generated for this purpose.

9. Device for sending a data packet stream over a network, said device comprising calculation means generating at least one corrective packet per application of a corrective function to a set of data packets, the device comprising means for applying this function to each line and each column of a matrix formed by data packets so as to generate said at least one corrective packet enabling the reconstruction of at least one packet lost in the line, respectively the column, to which is applied the error correction function, said corrective packet comprising an extended header, said extended header comprising an information representative of a chosen period to select the data packets to which said corrective function is applied.

10. Device to claim 9, wherein the corrective function is also applied to a line constituted by corrective packets resulting from the application of the corrective function to each column of the matrix generating an additional corrective packet.

11. Device according to claim 9 to 10, wherein the corrective function is also applied to a column constituted by corrective packets resulting from the application of the corrective function to each line of the matrix generating an additional corrective packet.

12. Device for receiving a data packet stream on a network containing calculation means of packets lost according to data packets and corrective packets received, the device has means to enable these calculation means to be applied to the lines and to the columns of a matrix of data packets of the stream as well as the corrective packets corresponding to these lines and these columns, said corrective packets comprising an extended header, said extended header comprising an information representative of a chosen period to select the data packets to which an error correction function is applied.

13. Device according to claim 12, comprising means to reconstruct the lost packets that comprise:
- means for storing the packets received in a matrix of D lines and L columns taking into account their sequence number,
- means for applying to each line and each column of the matrix containing at least one lost packet a reconstruction function of the missing packets, said means using the packets received and the corrective packet corresponding to the line or the column.

14. Device according to claim 13, wherein the reconstruction function is also applied to a line or a column of corrective packets by using an additional corrective packet generated for this purpose.
